# EUROPEAN PATENT APPLICATION

(11) **EP 3 048 509 A1**
(43) Date of publication of application: **27.07.2016**
(21) Application number: 15189618.0
(22) Date of filing: 13.10.2015
(51) Int. Cl.: G06F 1/18, H05K 5/02

(54) **ELECTRONIC DEVICE**

(30) Priority: 23.01.2015 TW 104201144
(71) Applicant: Arcadyan Technology Corp., Hsinchu 300 (TW)
(72) Inventor: Chen, Sheng-Chung, 310 Zhudong Township Hsinchu County (TW); Huang, Shih-Hsin, 300 Hsinchu City (TW)
(74) Representative: Krauns, Christian

(57) **Abstract**

An electronic device (100) including a housing (102) and a base frame (104) is provided. A first plane (S1) of the housing has a groove (CP) including a first connecting part (C1). A second plane (S2) of the housing has a second connecting part (C2). The base frame includes a third connecting part (C3) and a fourth connecting part (C4). In a first assembly mode, the third connecting part is connected to the first connecting part so that the base frame is fixed to the groove and the housing is supported in one orientation. In a second assembly mode, the fourth connecting part is connected to the second connecting part so that the base frame is fixed to the second plane of the housing and supports the housing with a third plane (S3) adjacent to the second plane in another orientation.

## Description

### BACKGROUND OF THE INVENTION

### Field of the Invention

The invention relates in general to an electronic device, and more particularly to an electronic device capable of providing different assembly modes.

### Description of the Related Art

In general, electronic devices, based on the original mechanism deign, normally only have one arrangement mode. For example, electronic devices such as Internet router and set-stop box are normally laid flat. However, such design implicitly restricts they user's flexibility in the arrangement of the devices, and may even make the devices hard to be stored.

Besides, for some wireless devices with in-built antennas, the original arrangement mode of these wireless devices actually reduces the radiation effect of antennas. Therefore, in order to improve the radiation effect, these devices need to be additionally equipped with an external antenna or need to adopt a special antenna structure. However, these solutions may increase the manufacturing cost and labor cost of the products.

Therefore, how to provide an electronic device capable of providing different assembly modes to support different arrangement modes has become a prominent task for the industries.

### SUMMARY OF THE INVENTION

The invention is directed towards an electronic device capable of providing different assembly modes to support different arrangement modes.

The present disclosure discloses an electronic device including a housing and a base frame. A first plane of the housing has a groove including a first connecting part. A second plane of the housing has a second connecting part. The base frame includes a third connecting part and a fourth connecting part. In a first assembly mode, the third connecting part is connected to the first connecting part so that the base frame is fixed to the groove. In a second assembly mode, the fourth connecting part is connected to the second connecting part so that the base frame is fixed to the second plane of the housing and supports the housing with a third plane adjacent to the second plane.

According to an electronic device of the present disclosure, the first plane is adjacent to the second plane and the third plane, and the second plane is adjacent to the third plane, so that the first plane, the second plane and the third plane respectively face different directions.

According to an electronic device of the present disclosure, in the first assembly mode, the housing is supported through the first plane alone. Or, the base frame is fixed to the groove and engaged with the housing, and the first plane is coplanar with the base frame, so that the housing is supported.

According to an electronic device of the present disclosure, in the first assembly mode, the first connecting part can be realized by a first slot, the third connecting part can be realized by a first protruding part opposite to the first slot, the first protruding part further includes an elastic structure, and when the base frame is fixed to the groove, the first protruding part is tightly engaged with the first slot through the elastic structure. Or, the first connecting part can be realized by a second protruding part, the second protruding part further includes an elastic structure, the third connecting part can be realized by a second slot opposite to the second protruding part, and when the base frame is fixed to the groove, the second protruding part is tightly engaged with the second slot through the elastic structure.

According to an electronic device of the present disclosure, in the second assembly mode, the base frame is fixed to the second plane and engaged with the housing, and the third plane is coplanar with the base frame so that the housing is supported.

According to an electronic device of the present disclosure, in the second assembly mode, the second connecting part can be realized by a third slot, the fourth connecting part can be realized by a third protruding part opposite to the third slot, the third protruding part further includes an elastic structure, and when the base frame is engaged with the housing, the third protruding part is tightly engaged with the third slot through the elastic structure.

According to an electronic device of the present disclosure, in the second assembly mode, the base frame further includes a connecting device, the receiving device is an indented structure, the second connecting part is disposed on the connecting device, and a second plane of the housing can be inwardly disposed in the connecting device, so that the fourth connecting part is connected to the second connecting part, and the first plane contacts the connecting device by the part adjacent to the third plane.

The above and other aspects of the invention will become better understood with regard to the following detailed description of the preferred but non-limiting embodiment (s). The following description is made with reference to the accompanying drawings.

### BRIEF DESCRIPTION OF THE DRAWINGS

FIG. 1 is a schematic diagram of an electronic device according to an embodiment of the present disclosure.
FIG. 2 is a schematic diagram of an electronic device in a first assembly mode according to an embodiment of the present disclosure.
FIG. 3 is a schematic diagram of an electronic device before a second assembly mode according to an embodiment of the present disclosure.
FIG. 4 is a schematic diagram of an electronic device in the second assembly mode according to an embodiment of the present disclosure.
FIG. 5 is a schematic diagram of an electronic device according to another embodiment of the present disclosure.
FIG. 6 is a schematic diagram of an electronic device according to another embodiment of the present disclosure.
FIG. 7 is a schematic diagram of a fourth connecting part and its corresponding second connecting part of base frame and according to an embodiment of the present disclosure.
FIG. 8 is a schematic diagram of a fourth connecting part and its corresponding second connecting part of base frame and according to another embodiment of the present disclosure.
FIG. 9 is a schematic diagram of a third connecting part and its corresponding first connecting part of a base frame according to an embodiment of the present disclosure.
FIG. 10 is a schematic diagram of a third connecting part and its corresponding first connecting part of a base frame according to an embodiment of the present disclosure.

### DETAILED DESCRIPTION OF THE INVENTION

A number of embodiments are disclosed below for elaborating the invention. However, the embodiments of the invention are for detailed descriptions only, not for limiting the scope of protection of the invention. Furthermore, secondary or unimportant elements are omitted in the accompanying diagrams of the embodiments for highlighting the technical features of the invention.

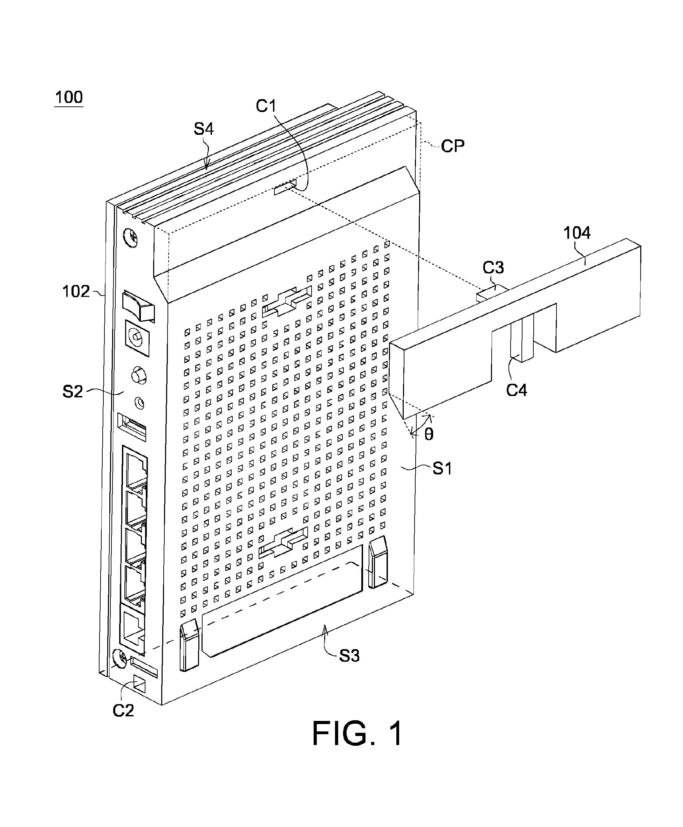

FIG. 1 is a schematic diagram of an electronic device 100 according to an embodiment of the present disclosure. The electronic device 100 includes a housing 102 and a base frame 104. The electronic device 100 can be realized by an Internet router, a set-top box, a stereo, an electronic game player or other consumer electronic products. In the example of FIG. 1, the electronic device 100 is an Internet router, but the present disclosure is not limited thereto.

As indicated in FIG. 1, a first plane S1 of the housing 102 has a groove CP for receiving the base frame 104. The base frame 104 can be fixed to the groove CP or detached from the same.

In the present embodiment, the groove CP includes a first connecting part C1, and a second plane S2 of the housing 102 has a second connecting part C2. The first plane S1 is, for example, a bottom surface of the flat laid electronic device 100, and the second plane S2 is, for example, adjacent to the first plane S1. In the example of FIG. 1, the groove CP is located at a position away from a third plane S3 of the housing 102 and adjacent to a fourth plane S4 opposite to the third plane S3. On the other hand, the second connecting part C2 is adjacent to the third plane S3 and away from the fourth plane S4. An inclination angle θ is formed by the groove CP of the housing 102 and a lateral side of the base frame 104 corresponding to the groove CP. The inclination angle θ can be realized by an acute angle, a right angle or an obtuse angle. In some embodiments, the groove CP can be formed on any plane of the housing 102. In some embodiments, the second connecting part C2 can be adjacent to the fourth plane S4 and away from the third plane S3. Therefore, when the base frame 104 is engaged with the second connecting part C2 through the fourth connecting part C4, the base frame 104 and the fourth plane S4 are laid upright to support the electronic device 100.

The base frame 104 includes a third connecting part C3 and a fourth connecting part C4. The third connecting part C3 of the base frame 104 extends along a direction perpendicular to the extending direction of the fourth connecting part C4. The third connecting part C3 and the first connecting part C1 have corresponding structures. For example, if the first connecting part C1 is a slot, then the third connecting part C3 will be a corresponding protruding part, and vice versa. Similarly, the fourth connecting part C4 and the second connecting part C2 have corresponding structures. For example, if the second connecting part C2 is a slot, then the fourth connecting part C4 will be a corresponding protruding part, and vice versa.

Although the first and the third connecting parts C1 and C3 and the second and the fourth connecting parts C2 and C4 are exemplified by cuboids and corresponding recesses in FIG. 1, the present disclosure is not limited thereto. The first and the third connecting parts C1 and C3 and the second and the fourth connecting parts C2 and C4 can be realized by any corresponding connecting or engaging devices. Additionally, the appearances of the housing 102, the groove CP and the base frame 104 can be adjusted according to actual needs, and any appearances would do as long as the base frame 104 can be received in the groove CP of the housing 102.

In an embodiment of the present disclosure, the housing 102 and the base frame 104 of the electronic device 100 have a first assembly mode and a second assembly mode to support different arrangement modes of the electronic device 100.

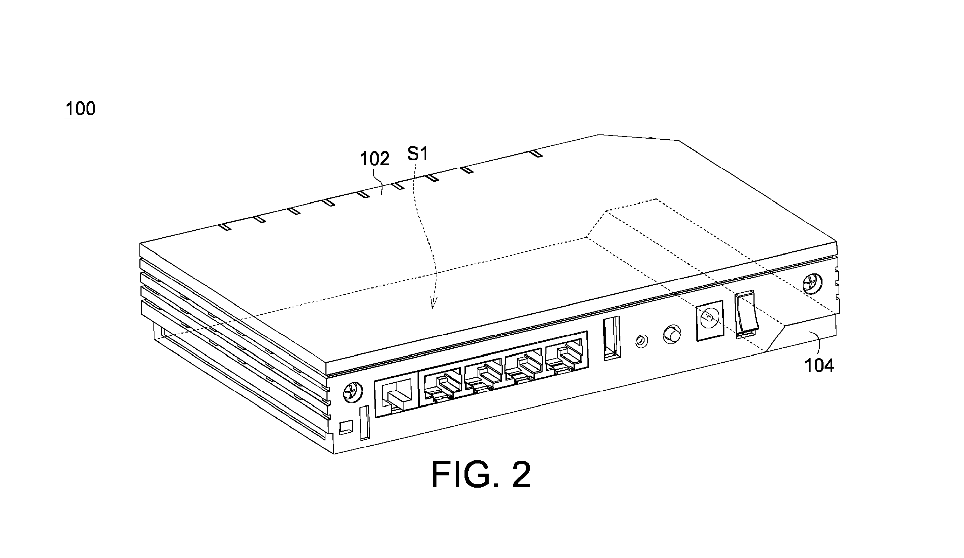

Referring to FIGS. 1 and 2. FIG. 2 is a schematic diagram of an electronic device 100 in a first assembly mode according to an embodiment of the present disclosure. In the first assembly mode, the third connecting part C3 is connected to the first connecting part C1 of the groove CP so that the base frame 104 is fixed to the groove CP. Meanwhile, a lower surface of the base frame 104 (opposite to the plane on which the third connecting part C3 is formed) is co-planar with the first plane S1 of the housing 102. Therefore, in the first assembly mode, the electronic device 100 using the co-plane formed by the base frame 104 and the first plane S1 as a bottom surface can be laid flat as indicated in FIG. 2.

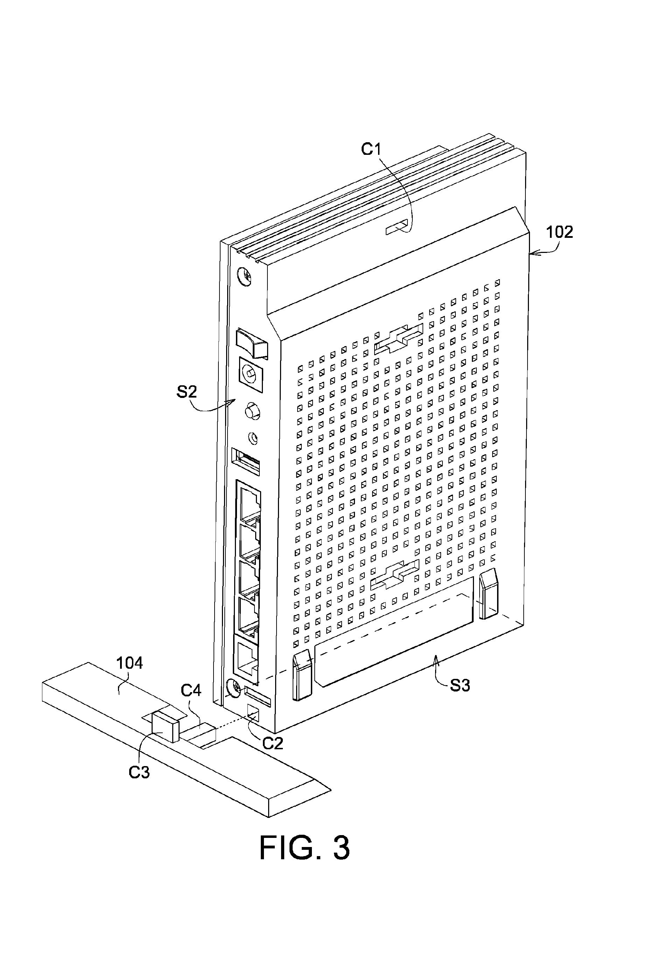

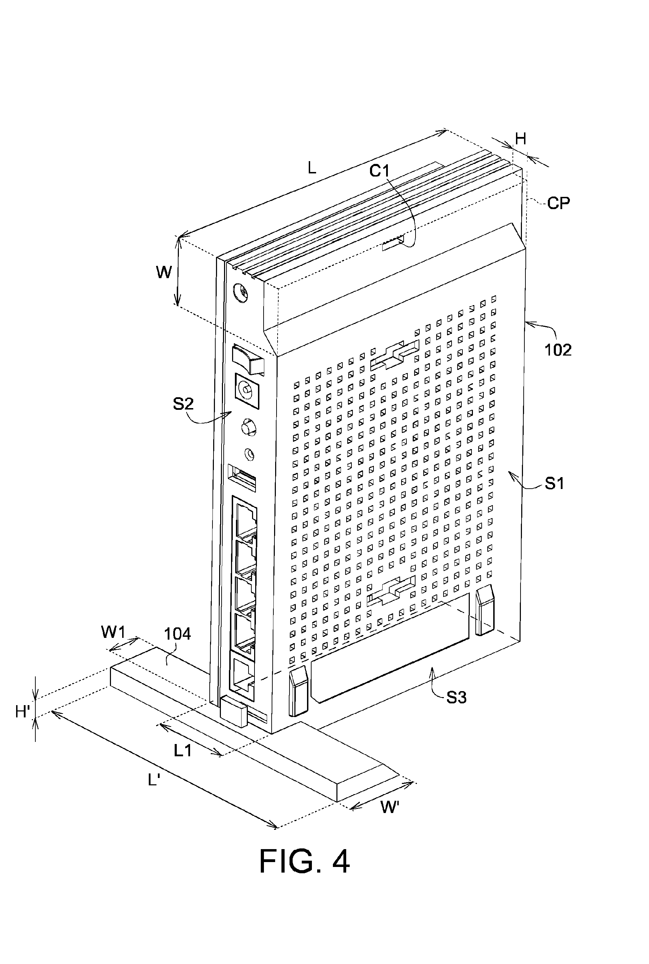

Referring to FIGS. 3 and 4. FIG. 3 is a schematic diagram of an electronic device 100 before a second assembly mode according to an embodiment of the present disclosure. FIG. 4 is a schematic diagram of an electronic device 100 in the second assembly mode according to an embodiment of the present disclosure. As indicated in FIG. 3, 4, in the second assembly mode, the fourth connecting part C4 is connected to the second connecting part C2 so that the base frame 104 is fixed to the second plane S2 of the housing 102 and supports the housing 102 with the third plane S3 adjacent to the second plane S2. Therefore, in the second assembly mode, the electronic device 100 using the co-plane formed by the base frame 104 and the third plane S3 as a bottom surface can be laid upright as indicated in FIG. 4. In the present assembly mode, the connecting groove of the base frame 104 is formed on a long side of the base frame 104 (such as a lateral side with length L' as indicated in FIG. 4), and the long side is perpendicular to the first plane S1 of the housing 102. Therefore, the base frame 104 provides a lateral support force opposite to the housing 102 to avoid the electronic device 100 being toppled over by an external force, so that the electronic device 100 can be steadily laid upright.

The fourth connecting part C4 is formed in the connecting groove of the base frame. In the second assembly mode, when the fourth connecting part C4 is connected to the second connecting part C2, the connecting groove is tightly engaged with the housing 102.

Refer to FIG. 4. The groove CP with length L, width W and height H can receive a strip-shaped base frame 104. In an embodiment, the dimension of the groove CP is fit, and the length L', width W' and height H' of the base frame 104 match with the length L, width W and height H of the groove CP.

In an embodiment, the depth W1 of the connecting groove is larger than a half of the length of a short side of the base frame 104 (such as a lateral side with length W' as indicated in FIG. 4), and the width L1 of the connecting groove is equivalent to the width of the second plane S2 of the housing 102, so that the base frame 104 can be tightly engaged with the housing 102. In some embodiments, to meet the needs of the design, the connecting grooves can be inclined towards the two ends of the base frame 104 and arranged in an asymmetric manner.

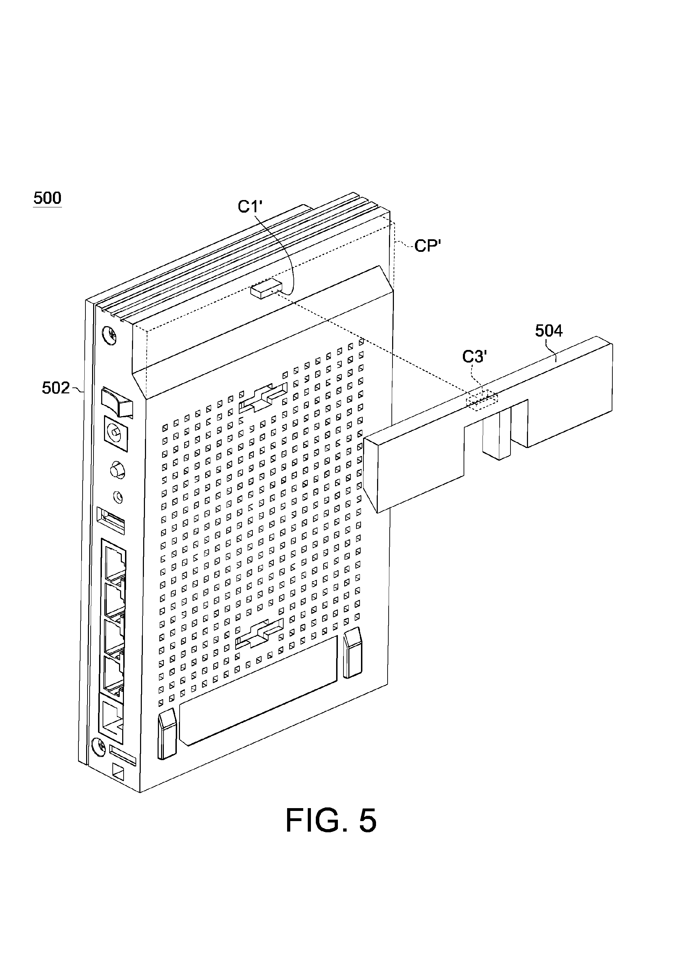

FIG. 5 is a schematic diagram of an electronic device 500 according to another embodiment of the present disclosure. The electronic device 500 is different from the above embodiments mainly in that: in the electronic device 500, the first connecting part C1' of the housing 502 is a protruding part, and the third connecting part C3' is a corresponding slot. Likewise, in the first assembly mode, the first connecting part C1' is tightly engaged with the third connecting part C3' so that the base frame 504 is fixed to the groove CP'.

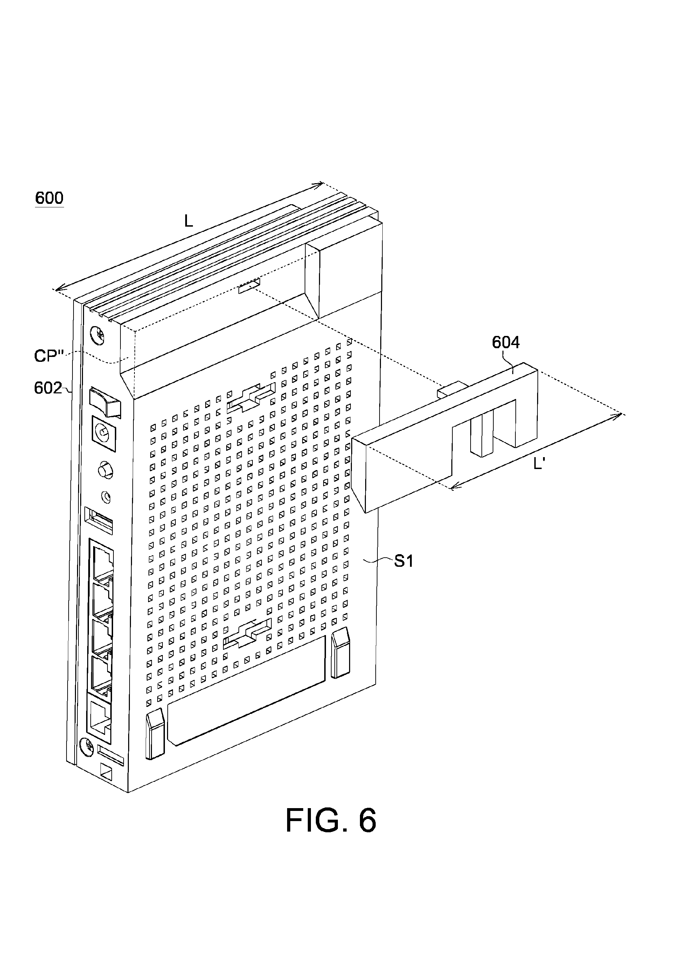

FIG. 6 is a schematic diagram of an electronic device 600 according to another embodiment of the present disclosure. The electronic device 600 is different from the above embodiments mainly in that: the length L' of the base frame 604 is smaller than the width L of the first plane S1, and the housing 602 has a groove CP" corresponding to the shape of the base frame 604.

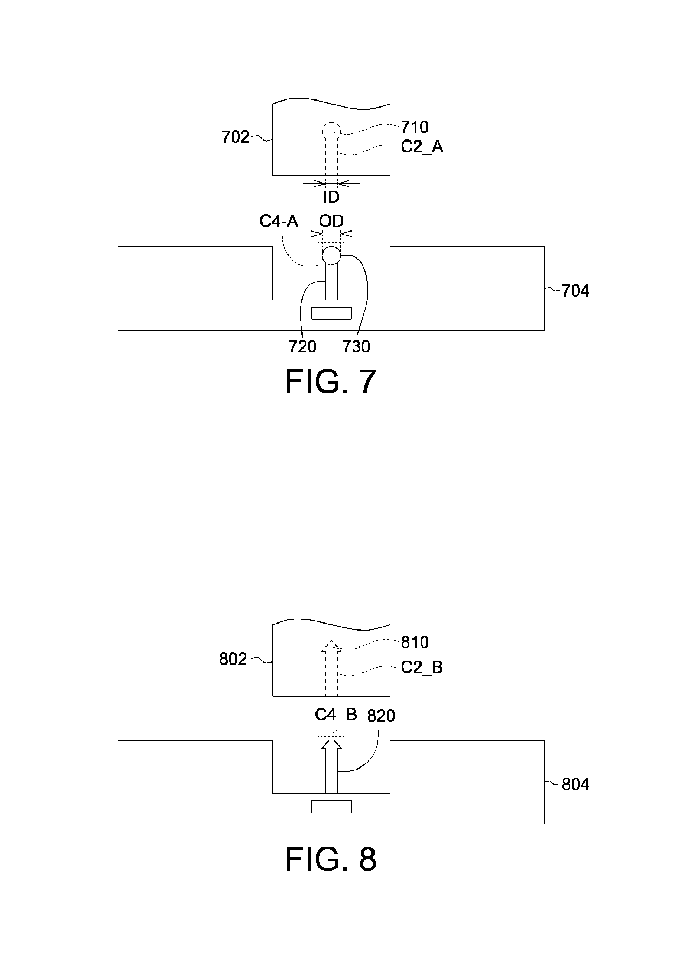

FIG. 7 is a schematic diagram of a fourth connecting part C4_A and its corresponding second connecting part C2_A of a base frame 704 according to an embodiment of the present disclosure. As indicated in FIG. 7, the second connecting part C2_A formed on the housing 702 has a slot 710. The fourth connecting part C4_A of the base frame 704 includes a protruding part 720. The structure of the slot 710 corresponds to that of the protruding part 720. Therefore, when the protruding part 720 is inserted into slot 710, the protruding part 720 can be engaged on an inner wall of the slot 710. In an embodiment, one end of the protruding part 720 has a bump 730, and the outer diameter OD of the bump 730 is larger than the inner diameter ID of the slot 710 in an opening on a surface of the housing 702.

FIG. 8 is a schematic diagram of a fourth connecting part C4_B and its corresponding second connecting part C2_B of a base frame 804 according to another embodiment of the present disclosure. As indicated in FIG. 7B, the second connecting part C2_B formed on the housing 802 has a slot 810. The fourth connecting part C4_B includes a protruding part 820. The structure of the slot 810 corresponds to that of the protruding part 820. In the present embodiment, the protruding part 820 is an elastic member. When the elastic member 820 is inserted into slot 810, the elastic member 820 can lean on the inner wall of the slot 810 to fix the base frame 804. In an embodiment as indicated in FIG. 8, the elastic member 820 is realized by a pair of elastic rods and the terminal end of each elastic rod has a barb.

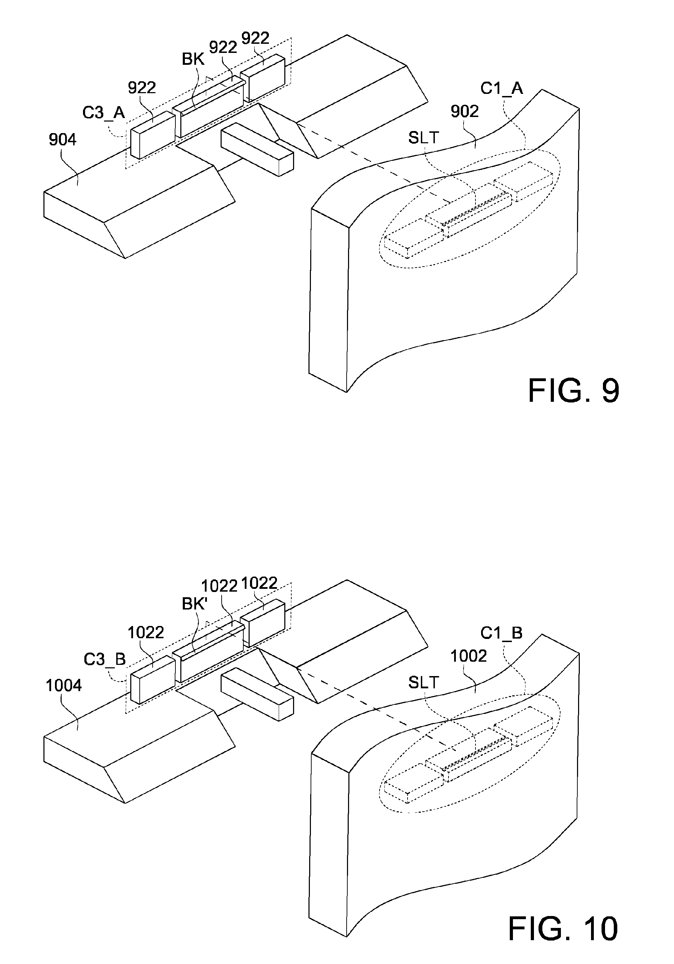

FIG. 9 is a schematic diagram of a third connecting part C3_A and its corresponding first connecting part C1_A of a base frame 904 according to an embodiment of the present disclosure. As indicated in FIG. 9, the first connecting part C1_A has a slot. The third connecting part C3_A includes a protruding part. The slot structure of the first connecting part C1_A corresponds to that of the protruding part of the third connecting part C3_A. When the protruding part is inserted into slot, the protruding part is engaged on an inner wall of the slot. In an embodiment as indicated in FIG. 9, the inner wall of the slot has an opening SLT. The first connecting part C1_A includes at least one plug plate 922. One end of the at least one plug plate 922 has a bump BK. When the at least one plug plate 922 is inserted into slot 910, the bump BK is engaged in an opening SLT on an inner wall of the slot.

FIG. 10 is a schematic diagram of a third connecting part C3_B and its corresponding first connecting part C1_B of a base frame 1004 according to an embodiment of the present disclosure. As indicated in FIG. 10, the first connecting part C1_B has a slot. The third connecting part C3_A includes a protruding part. The structure of the first connecting part C1_B slot corresponds to the third connecting part C3_B protruding part. Like the previous embodiment, the protruding part of the third connecting part C3_A includes at least one plug plate 1022. One end of the at least one plug plate 1022 has a barb BK'. When the at least one plug plate 1022 is inserted into slot, the barb BK' can be engaged with the inner wall of the slot.

Although the protruding part is exemplified by 3 plug plates in FIGS. 9 and 10, the present disclosure is not limited thereto. The number of plug plates is subjected to actual needs, and the plug plates can have different types of design. In some embodiments, the first connecting part and its corresponding third connecting part can be realized by a hole and a corresponding plug, and any design would do as long as the first connecting part and its corresponding third connecting part can be connected to each other and fix the base frame firmly.

To summarize, the electronic device according to the above embodiments of the present disclosure has two assembly modes. In the first assembly mode, the electronic device can hide the base frame in a corresponding groove, and can be laid according to the first type of arrangement (such as laid flat). In the second assembly mode, the base frame can be detached from the groove and connected to a lateral side of the electronic device, such that the electronic device can be laid according to the second type of arrangement (such as laid upright). In the second assembly mode, the base frame provides a lateral support force opposite to the housing to avoid the electronic device being toppled over by an external force, so that the electronic device can be steadily laid upright. Thus, the electronic device of the present disclosure provides more flexibility of arrangement to the user, and is easier to be stored. Besides, if the electronic device has the function of wireless transmission, the reception problem can be resolved by way of adjusting the arrangement of the device. For example, the electronic device can be laid upright to increase its antenna efficiency.

While the invention has been described by way of example and in terms of the preferred embodiment (s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. An electronic device (100), **characterized in that** the electronic device comprises:
a housing (102), wherein a first plane (S1) of the housing has a groove (CP) comprising a first connecting part (C1), and a second plane (S2) of the housing has a second connecting part (C2); and
a base frame (104), comprising a third connecting part (C3) and a fourth connecting part (C4), wherein in a first assembly mode, the third connecting part (C3) is connected to the first connecting part (C1) so that the base frame is fixed to the groove (CP), and in a second assembly mode, the fourth connecting part (C4) is connected to the second connecting part (C2) so that the base frame (104) is fixed to the second plane (S2) of the housing (102) and supports the housing (102) with a third plane (S3) adjacent to the second plane (S2).

2. The electronic device according to claim 1, wherein the first connecting part (C1_A) has a first slot, the third connecting part (C3_A) comprises a first protruding part, and when the first protruding part is inserted into the first slot, the first protruding part (C1_A) is engaged on an inner wall of the first slot.

3. The electronic device according to claim 2, wherein the inner wall of the first slot has an opening (SLT), the first protruding part comprising at least one plug plate (922), one end of the at least one plug plate (922) comprises a barb (BK), and when the at least one plug plate is inserted into the first slot, the barb (BK) is engaged in the opening (SLT) on the inner wall of the first slot.

4. The electronic device according to any one of claims 1 to 3, wherein the second connecting part (C2_A) has a second slot (710), the fourth connecting part comprises a second protruding part (720), and when the second protruding part (720) is inserted into the second slot, the second protruding part (720) is engaged on an inner wall of the second slot (710).

5. The electronic device according to claim 4, wherein the second protruding part (820) is an elastic member, and when the elastic member is inserted into the second slot (810), the elastic member leans on the inner wall of the second slot (810).

6. The electronic device according to claim 5, wherein the elastic member is a pair of elastic rods and the terminal end of each elastic rod has a barb.

7. The electronic device according to any one of claims 4 to 6, wherein one end of the second protruding part (720) has a bump (730) having an outer diameter (OD) larger than an inner diameter (ID) of the second slot (710) in an opening on the surface of the housing (720).

8. The electronic device according to any one of claims 1 to 7, wherein the groove (CP) is located at a position away from the third plane (S3) of the housing and adjacent to a fourth plane (S4) opposite to the third plane (S3).

9. The electronic device according to any one of claims 1 to 8, wherein the third connecting part (C3) of the base frame (104) extends along a direction perpendicular to the extending direction of the extending direction of the fourth connecting part (C4).

10. The electronic device according to any one of claims 1 to 9, wherein the base frame (104) has a connecting groove, the fourth connecting part (C4) is formed on the connecting groove, and in the second assembly mode, the connecting groove is tightly connected to the housing (102).

11. The electronic device according to claim 9 or 10, wherein the base frame (104) is strip-shaped, the connecting groove is formed on a long side of the base frame, and the depth of the connecting groove is larger than a half of the length of a short side of the base frame (104).

12. The electronic device according to claim 10 or 11, in the second assembly mode, the long side of the base frame (104) is perpendicular to the first plane (S1) of the housing.

13. The electronic device according to any one of claims 1 to 12, wherein the third connecting part (C3) is formed on an upper surface of the base frame (104), and in the first assembly mode, a lower surface of the base frame opposite to the upper surface is co-planar with the first plane (S1) of the housing (102).

14. The electronic device according to any one of claims 1 to 13, wherein the third connecting part (C3) is formed on an upper plane of the base frame (104), and in the second assembly mode, a lower surface of the base frame (104) opposite to the upper surface is co-planar with the third plane (S3) of the housing (102).
